**Europäisches Patentamt**

**European Patent Office**

**Office européen des brevets**

(19)

(11) Veröffentlichungsnummer: **0 217 223 B1**

# EUROPÄISCHE PATENTSCHRIFT

(12)

(45) Veröffentlichungstag der Patentschrift: 23.05.90

(21) Anmeldenummer: 86112801.5

(22) Anmeldetag: 16.09.86

(51) Int. Cl.⁵: **H03M 1/06**, G05F 1/567 // (H03M1/06, 1:78)

(54) **Digital-Analog-Umsetzer mit Temperaturkompensation.**

(30) Priorität: **30.09.85 DE 3534915**

(43) Veröffentlichungstag der Anmeldung: **08.04.87 Patentblatt 87/15**

(45) Bekanntmachung des Hinweises auf die Patenterteilung: **23.05.90 Patentblatt 90/21**

(84) Benannte Vertragsstaaten: **AT BE CH DE FR GB IT LI LU NL SE**

(56) Entgegenhaltungen:
**IEEE ELECTRO, Band 8, Session 4/3, 1983, Seiten 1-3, New York, US; E. RITTER: "Single chip digital to analog converter systems reduce board level component count"**
**ELECTRONICS, Band 56, Nr. 13, Juni 1983, Seiten 156-159, New York, US; P. PRAZAK: "Low-cost digital-to-analog converter makes beautiful music in disk players"**
**ELECTRONICS LETTERS, Band 6, Nr. 11, Mai 1980, Seiten 418-419, Hitchin, Herts., GB; A. NEDUNGADI: "High current class AB convertor technique"**

(73) Patentinhaber: **Siemens Aktiengesellschaft, Wittelsbacherplatz 2, D-8000 München 2(DE)**

(72) Erfinder: **Dielacher, Franz, Dipl.-Ing., Auer von Welsbachstrasse 51, A-9500 Villach(AT)**

## Beschreibung

Die Erfindung betrifft einen Digital-Analog-Umsetzer nach dem Oberbegriff des Patentanspruchs 1.

Derartige gattungsgemäße Digital-Analog-Umsetzer dienen beispielsweise zur Umwandlung einer Dualzahl in eine analoge Spannung. Verschiedene Schaltungsprinzipien sind in dem Buch von U. Tietze und Ch. Schenk, "Halbleiter-Schaltungstechnik", Springer-Verlag, Berlin, Heidelberg, New York, 5. überarbeitete Auflage 1980, Seiten 633 ff. beschrieben. Dabei dient eine Referenzspannung zur Versorgung eines Widerstands- und Schalternetzwerks, das abhängig vom Schaltzustand der einer dualen Wichtung entsprechenden Schalter in den einzelnen Netzwerkszweigen gewichtete Ströme erzeugt, die mit Hilfe des nachgeschalteten gegengekoppelten Operationsverstärkers aufsummiert und in eine Spannung umgewandelt werden.

Je nach der Anzahl der umzuwandelnden Dualstellen sind dabei an die Genauigkeit der Widerstände des Widerstands- und Schalternetzwerks und des Gegenkopplungswiderstandes des nachgeschalteten Operationsverstärkers hohe Anforderungen zu erfüllen. Ein wichtiger Parameter für die Genauigkeit eines Digital-Analog-Umsetzers ist seine Unabhängigkeit gegenüber Temperaturänderungen.

In dem Artikel "Single chip digital to analog converter systems reduce board level component count" von E. Ritter, IEEE Electro, Band 8, Session 4/3, 1983, Seiten 1-3, New York, US ist ein Digital-Analog-Umsetzer beschrieben, der von einer Referenzspannungsquelle gespeist wird und ein Stromteilernetzwerk mit geschalteten Stromquellen enthält. Um bei diesem Umsetzerkonzept eine von der Temperatur unabhängige Ausgangsspannung zu erhalten, müßte der Rückkoppelwiderstand des ausgangsseitigen Strom-Spannungsumsetzers und das Widerstandsnetzwerk den selben Temperaturkoeffizienten haben. Das ist üblicherweise nicht realisierbar, da das Widerstandsnetzwerk auch Schalter enthält, die einen anderen Temperaturkoeffizienten aufweisen als die Widerstände.

Aus Electronics letters, Band 6, Nr. 22, Mai 1980, Seiten 418 bis 319, Hitchin, Herts., GB; A. Nedungadi: "High current class AB Converetor technique" ist prinzipiell bekannt, bei spannungs- und stromgesteuerten Hochstromquellen für Verstärker der Klasse AB Stromquellen aus Spannungsquellen abzuleiten.

In der DE-OS 31 45 889 ist eine Methode zur Kompensation des Temperaturgangs eines gattungsgemäßen Digital-Analog-Umsetzers beschrieben, die neben den Widerständen des Widerstands- und Schalternetzwerks die Schalterwiderstände berücksichtigt und die Bemessung des Rückkopplungswiderstandes im Gegenkopplungszweig des Ausgangsoperationsverstärkers an diese Widerstände anpaßt. Eine exakte Temperaturkompensation ist dabei jedoch nicht verwirklicht.

Der Erfindung liegt die Aufgabe zugrunde, einen durch ein Widerstands- und Schalternetzwerk realisierten Digital-Analog-Umsetzer anzugeben, dessen Ausgangsspannung von der Temperatur unabhängig ist.

Diese Aufgabe wird bei einem Digital-Analog-Umsetzer der eingangs genannten Art erfindungsgemäß durch die Merkmale des kennzeichnenden Teils des Patentanspruchs 1 gelöst.

Weitere Ausgestaltungen des Erfindungsgedankens sind in Unteransprüchen gekennzeichnet.

Die Erfindung wird im folgenden anhand von in den Figuren der Zeichnung dargestellten Ausführungsbeispielen näher erläutert. Es zeigt:

Fig. 1 ein schematisches Schaltbild eines Digital-Analog-Umsetzers mit einer temperaturunabhängigen Ausgangsspannung und

Fig. 2 ein Schaltbild einer zweiten Ausführungsform einer Referenzstromquelle zum Einsatz in einen gattungsgemäßen Digital-Analog-Umsetzer.

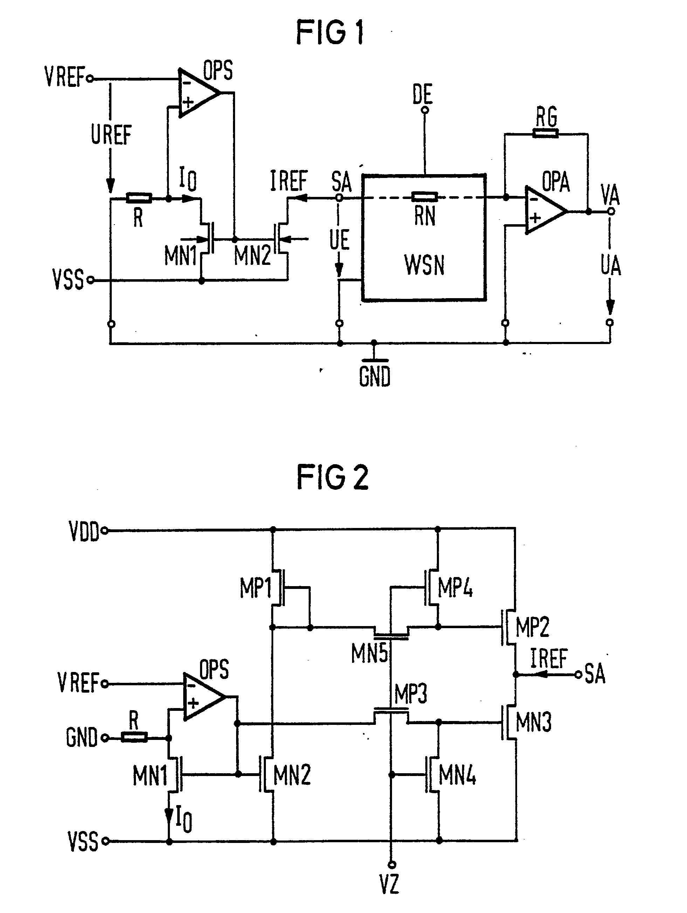

Gemäß Fig. 1 enthält ein erfindungsgemäßer Digital-Analog-Umsezter eine Stromquelle, die mit Hilfe einer Referenzspannung UREF und einem den Referenzstrom bestimmenden Widerstand R gebildet wird und ein Widerstands- und Schalter-netzwerk WSN speist, dem ein invertierender Operationsverstärker OPA mit Gegenkopplungswiderstand RG von seinem Ausgang zu seinem invertierenden Eingang nachgeschaltet ist. Der Ausgang des Operationsverstärkers OPA ist gleichzeitig mit der Klemme VA des Digital-Analog-Umsetzers verbunden, die gegenüber dem Bezugspotential GND die dem umgesetzten digitalen Eingangscode entsprechende analoge Ausgangsspannung UA besitzt.

Das Widerstands- und Schalternetzwerk WSN wird über die Klemme SA versorgt, in die erfindungsgemäß der Referenzstrom IREF eingespeist werden soll und die gegenüber dem Bezugspotential GND die Spannung UE besitzt. Das Widerstands- und Schalternetzwerk WSN wird vom an der Eingangsklemme DE liegenden digitalen Eingangscode gesteuert, wobei sich der gestrichelt angedeutete Ersatzwiderstand RN des Netzwerks aus dem digitalen Eingangscode bzw. dem durch ihn geschalteten Schalternetzwerk ergibt. Ausführungsformen eines derartigen Widerstands-und Schalternetzwerks WSN sind in den vorgenannten Veröffentlichungen dargestellt.

Erfindungswesentlich ist nun, daß die Referenzspannung am Eingang des Digital-Analog-Umsetzers mit Hilfe eines Widerstandes R in einen Referenzstrom IREF zur Einspeisung in das Widerstands- und Schalternetzwerk WSN umgewandelt wird und daß der den Referenzstrom IREF bestimmende Widerstand R den gleichen Temperaturgang besitzt wie der Rückkopplungswiderstand RG im Gegenkopplungszweig des Ausgangsoperationsverstärkers OPA. Im konkreten Ausführungsbeispiel gemäß Fig. 1 ist die Stromquelle eine Stromspiegelschaltung, in der die Größe des Eingangsstroms Io durch den Widerstand R und die Größe des Ausgangs-Referenzstroms IREF durch das Übersetzungsverhältnis des Stromspiegels gegeben ist.

Der Eingangstransistor MN1 des Stromspiegels ist mit seinem Ausgangskreis über den Widerstand R mit dem Bezugspotential GND und mit seinem Steuereingang mit dem Ausgang eines weiteren Operationsverstärkers OPS verbunden, an dessen nichtinvertierenden Eingang das Potential des Verbindungspunktes des Widerstands R mit dem Ausgangskreis des Eingangstransistors MN1 liegt. Der invertie-rende Eingang des Operationsverstärkers OPS ist mit einer Klemme VREF verbunden, an der ein Referenzpotential mit der Spannung UREF gegenüber dem Bezugspotential GND liegt.

Der Steueranschluß des Eingangstransistors MN 1 des Stromspiegels und der Ausgang des weiteren Operationsverstärkers OPS sind gemeinsam an den Steueranschluß des Ausgangstransistors MN2 des Stromspiegels angeschlossen, durch dessen Ausgangskreis der Referenzstrom IREF fließt. Der als Kollektor bzw. Drain wirkende Anschluß des Ausgangstransistors MN2 des Stromspiegels ist mit der Versorgungsklemme SA des Widerstands- und Schalternetzwerks WSN verbunden, während die als Emitter bzw. als Source dienenden Anschlüsse der Ausgangskreises des Stromspiegels aus den Transistoren MN1 und MN2 mit einer ein Potential führenden Klemme VSS verbunden sind.

Im Ausführungsbeispiel enthält die Stromspiegelschaltung Metalloxid-Transistoren vom n-Kanal-Typ, obwohl sich die Stromspiegelschaltung auch mit anderen Feldeffekttransistoren oder mit Bipolartransistoren realisieren läßt.

Der in das Widerstands- und Schalternetzwerk WSN fließende Referenzstrom IREF ergibt sich aus dem Eingangsstrom Io des Stromspiegels multipliziert mit dessen Übersetzungsverhältnis, d.h. im wesentlichen mit dem Verhältnis von Kanalweite zu Kanallänge des Transistors MN2 bezogen auf das zugeordnete Weiten- zu Längen-Verhältnis des Transistors MN1. Der Eingangsstrom Io des Stromspiegels ergibt sich als Quotient aus der Referenzspannung UREF und dem Widerstand R.

Die Ausgangsspannung UA des Digital-Analog-Umsetzers wird durch die negative Eingangsspannung UE, den aktuellen Ersatzwiderstand RN des Widerstands- und Schalternetzwerks WSN und den Gegenkopplungswiderstand RG des Ausgangsoperationsverstärkers OPA gebildet. So ist die Ausgangsspannung UA gleich der negativen Eingangsspannung UE multipliziert mit dem Quotienten aus Gegenkopplungswiderstand RG und dem aktuellen Widerstand RN des Widerstands- und Schalternetzwerks WSN. Andererseits ist die Eingangsspannung UE gleich dem Produkt aus dem aktuellen Widerstand RN und dem in das Netzwerk WSN fließenden Referenzstrom IREF.

Faßt man die geltenden Beziehungen zwischen Strömen und Spannungen für das erfindungsgemäße Netzwerk gemäß Fig. 1 zur Ausgangsspannung UA als Funktion der Referenzspannung UREF zusammen und berücksichtigt man, daß der Rückkopplungswiderstand RG des Gegenkopplungskreises des Ausgangsoperationsverstärkers OPA wertmäßig gleich, ein Mehrfaches oder ein Bruchteil des Widerstands R der Stromquelle ist, dann hängt der Betrag der Ausgangsspannung UA multiplikativ von der Referenzspannung UREF, dem Multiplikationsfaktor des Widerstandes RG bezogen auf den Widerstand R und vom Übersetzungsverhältnis des aus den beiden Transistoren MN1 und MN2 gebildeten Stromspiegels ab. Aus dieser Summenformel haben sich die in den vorgenannten Einzelbeziehungen aufgeführten Widerstandswerte R, RG und RN für das Widerstands- und Schalternetzwerk WSN herausgekürzt. Das bedeutet, daß der Temperaturgang der Widerstände und des Widerstands- und Schalternetzwerks WSN kompensiert ist, wenn der Temperaturgang des Gegenkopplungswiderstandes RG und des den Referenzstrom IREF bestimmenden Widerstandes R übereinstimmt.

Es liegt im Rahmen der Erfindung, an Stelle der gemäß Fig. 1 vorgesehenen Stromquelle eine Kaskode- oder eine Wilson- bzw. Improved-Wilson-Stromquelle zu verwenden, um den Innenwiderstand der Stromquelle weiter zu erhöhen. Weiterhin können erfindungsgemäß schaltbare bipolare Stromquellen, wahlweise auch in Kaskode-, Wilson- oder Improved-Wilson-Ausführung eingesetzt werden. Bei bipolaren Stromquellen zur Einspeisung eines bipolaren Differenzstroms IREF in das Widerstands- und Schalternetzwerk WSN ergibt sich entsprechend eine bipolare Ausgangsspannung UA.

Fig. 2 gibt ein Ausführungsbeispiel einer schaltbaren bipolaren Stromquelle an, die Gegenstand der korrespondierenden Patentanmeldung VPA 85 E 5303 DE ist. Gemäß Fig. 2, in der gleiche Elemente wie in Fig. 1 mit gleichen Bezugszeichen versehen sind, wird die bipolare Stromquelle von einer zwischen zwei Klemmen VDD und VSS einer bipolaren Speisespannungsquelle liegenden Spannung versorgt. Die Schaltung enthält einen ersten Stromspiegel mit Metalloxid-Transistoren vom n-Kanal-Typ und einen zweiten Stromspiegel mit Metalloxid-Transistoren vom p-Kanal-Typ, die hintereinander geschaltet sind und deren Ausgangstransistoren über Transistorschalter wechsel-weise angesteuert werden. In den ersten Stromspiegel wird der Eingangsstrom Io eingespeist, der im Ausgangskreis des Eingangstransistors MN1 fließt. Der als Drain dienende Anschluß des Transistors MN1 ist über einen Widerstand R mit der Klemme GND für das Bezugspotential und mit dem nichtinvertierenden Eingang eines Operationsverstärkers OPS verbunden, an dessen invertierenden Eingang die Klemme VREF mit der Referenzspannung UREF gegenüber dem Bezugspotential angeschlossen ist. Der Ausgang des Operationsverstärkers OPS steuert das Gate des Transistors MN1. Der erste Stromspiegel enthält weiter den Spiegeltransistor MN2 und den Ausgangstransistor MN3. Während die Gates der Transistoren MN1 und MN2 direkt miteinander und mit dem Ausgang des Operationsverstärkers OPS verbunden sind, liegt vor dem Gate des Transistors MN3 der Ausgangskreis eines Transistors MP3. Die als Source dienenden Anschlüsse der Transistoren MN1, MN2 und MN3 sind mit der Klemme VSS der Speisespannungsquelle verbunden. Zusätzlich liegt zwischen dem Gate des Transistors MN3 und der Klemme VSS der Speisespannungsquelle der Ausgangskreis eines Transistors MN4.

In Serie zu den Ausgangskreisen der Transistoren MN2 und MN3 liegen die Ausgangskreise der Transistoren MP1 und MP2 des zweiten Stromspiegels. Das Gate des Transistors MP1 ist direkt mit dem Verbindungspunkt der Ausgangskreise der Transistoren MN2 und MP1 und über den Ausgangskreis eines Transistors MN5 mit dem Gate des Transistors MP2 verbunden. Die als Source dienenden Anschlüsse der Transistoren des zweiten Stromspiegels sind mit der Klemme VDD der Speisespannungsquelle verbunden. Das Gate des Transistors MP2 liegt über dem Ausgangskreis eines Transistors MP4 ebenfalls an der Klemme VDD. Am Verbindungspunkt der Ausgangskreise der beiden Ausgangstransistoren MN3 und MP2 liegt die Klemme SA für den Stromausgang der Schaltung und die Einspeisung in das Widerstands- und Schalternetzwerk WSN. Die Transistoren MN4 und MN5 sind dabei vom n-Kanal-Typ und die Transistoren MP3 und MP4 vom p-Kanal-Typ; die Gates dieser letztgenannten vier Transistoren sind miteinander an einer Klemme VZ angeschlossen.

Der in der Schaltung fließende Eingangsstrom Io wird zunächst in den Spiegeltransistor MN2 gespiegelt und fließt damit auch durch den Eingangstransistor MP1 des zweiten Stromspiegels. Abhängig vom Vorzeichen eines an der Klemme VZ liegenden Potentials werden nun entweder die Transistoren MN4 und MN5 gesperrt und die Transistore MP3 und MP4 in den leitenden Zustand geschaltet oder paarweise umgekehrt.

Bei einem negativen Potential an der Klemme VZ leitet der Transistor MP3 und der Transistor MN4 sperrt. Der Eingangsstrom Io wird dann entsprechend dem Übersetzungsverhältnis des ersten Stromspiegels, d.h. im wesentlichen entsprechend dem Verhältnis von Kanalweite zu Kanallänge des Transistors MN3 bezogen auf den Transistor MN1 in den Transistor MN3 gespiegelt. Der gleichzeitig durch die Transistoren MN2 und MP1 fließende Strom hat auf den Ausgangsstrom der Schaltung keinen Einfluß, da bei negativem Potential an der Klemme VZ der Transistor MN5 sperrt und der Transistor MP4 leitet, so daß der Ausgangstransistor MP2 des zweiten Stromspiegels gesperrt wird.

Bei einem positiven Potential an der Klemme VZ sind die Verhältnisse genau umgekehrt, d.h. der Transistor MP3 sperrt und der Transistor MN4 leitet, so daß der Ausgangstransistor MN3 sicher sperrt. Da andererseits in diesem Fall der Transistor MN5 leitet und der Transistor MP4 gesperrt ist, wird der Eingangsstrom Io zunächst gemäß dem Übersetzungsverhältnis der Transistoren MN2 zu MN1 des ersten Stromspiegels in den Transistor MN2 gespiegelt. Dieser dann ebenfalls durch den Transistor MP1 fließende Strom wird gemäß dem Übersetzungsverhältnis des zweiten Stromspiegels, d.h. gemäß dem Übersetzungsverhältnis der Transistoren MP2 zu MP1 in den Transistor MP2 gespiegelt. Abhängig vom Potential der Klemme VZ ist damit der in die Ausgangsklemme SA fließende Referenz-strom IREF entweder negativ oder positiv.

Zwischen den Ausgangskreisen der Transistoren MN2 und MP1 können ein, insbesondere zwei gleiche Widerstände liegen, die zur Symmetrierung der Schaltung bzw. zur Gewährleistung gleicher Arbeitspunkte der Transistoren dienen, wenn die Last von der Klemme SA gegen die Klemme GND geschaltet ist. Die bipolare Stromquelle kann mit anderen Feldeffekttransistoren oder Bipolartransistoren aufgebaut werden.

**Patentansprüche**

1. Digital-Analog-Umsetzer mit Temperaturkompensation, mit Spannungsausgang mit einer Referenzspannung (UREF), mit einem Widerstands- und Schalternetzwerk (WSN) zur Umwandlung eines digitalen Eingangscodes in einen analogen Ausgangsstrom und mit einem durch einen Rückkopplungswiderstand (RG) gegengekoppelten invertierenden Operationsverstärker (OPA), dadurch gekennzeichnet, daß eine Referenzstromquelle mit Hilfe der Referenzspannung (UREF) und eines den Referenzstrom (IREF) bestimmenden Widerstands (R) gebildet wird, die das Widerstands- und Schalternetzwerk (WSN) speist und daß der Widerstand (R) den gleichen Temperaturgang wie der Rückkopplungswiderstand (RG) besitzt.

2. Digital-Analog-Umsetzer nach Anspruch 1, dadurch gekennzeichnet, daß der Rückkopplungswiderstand (RG) im Gegenkopplungszweig des Operationsverstärkers (OPA) den gleichen Wert des den Referenzstrom (IREF) bestimmenden Widerstandes (R) besitzt.

3. Digital-Analog-Umsetzer nach Anspruch 1 oder 2, dadurch gekennzeichnet, daß die Referenzstromquelle einen Stromspiegel (MN1, MN2; MN1, MN2, MN3, MP1, MP2) enthält, dessen Referenz-Eingangsstrom (Io) durch den Widerstand (R) und die Referenzspannung (UREF) bestimmt wird.

4. Digital-Analog-Umsetzer nach Anspruch 1 bis 3, dadurch gekennzeichnet, daß der Eingangstransistor (MN1) des Stromspiegels mit seinem Ausgangskreis über den Widerstand (R) mit einem Bezugspotential (GND) und mit seinem Steuereingang mit dem Ausgang eines weiteren Operationsverstärkers (OPS) verbunden ist, an dessen invertierenden Eingang (-) das Referenzpotential (VREF) und an dessen nicht invertierenden Eingang (+) das Potential des Verbindungspunktes des Widerstandes (R) mit dem Ausgangskreis des Eingangstransistors (MN1) liegt.

5. Digital-Analog-Umsetzer nach Anspruch 1 bis 4, dadurch gekennzeichnet, daß die Referenzstromquelle durch eine bipolare Referenzstromquelle gebildet wird.

6. Digital-Analog-Umsetzer nach Anspruch 5, dadurch gekennzeichnet, daß die bipolare Referenzstromquelle von einer bipolaren Spannungsquelle (VDD, VSS) versorgt wird und einen ersten Stromspiegel (MN1, MN2, MN3) mit Transistoren eines Typs und einen zweiten Stromspiegel (MP1, MP2) mit Transistoren vom anderen Typ enthält, die Eingangs- und Ausgangstransistoren besitzen, daß die Stromspiegel hintereinander geschaltet sind und ihre Ausgangstransistoren abschaltbar sind.

7. Digital-Analog-Umsetzer nach Anspruch 5 oder 6, dadurch gekennzeichnet, daß der erste Stromspiegel (MN1, MN2, MN3) einen Spiegeltransistor (MN2) enthält, der mit seinem Ausgangskreis in Serie zum Ausgangskreis des Eingangstransistors (MP1) des zweiten Stromspiegels (MP1, MP2) liegt.

8. Digital-Analog-Umsetzer nach Anspruch 5 bis 7, **dadurch gekennzeichnet**, daß der Eingangstransistor (MP1) des zweiten Stromspiegels (MP1, MP2) als Diode geschaltet ist.

9. Digital-Analog-Umsetzer nach Anspruch 5 bis 8, **dadurch gekennzeichnet**, daß den Steueranschlüssen der Ausgangstransistoren (MN3, MP2) jeweils der Ausgangskreis eines Transistors (MP3, MN5) vorgeschaltet und den Steueranschlüssen und den speisespannungsseitigen Ausgangsanschlüssen der Ausgangstransistoren (MN3, MP2) jeweils der Ausgangskreis eines Transistors (MN4, MP4) parallel geschaltet ist.

10. Digital-Analog-Umsetzer nach Anspruch 5 bis 9, **dadurch gekennzeichnet**, daß die vorgeschalteten Transistoren (MP3, MN5) vom entgegengesetzten Typ und die parallelgeschalteten (MN4, MP4) vom gleichen Typ wie die zugehörigen Ausgangstransistoren (MN3, MP2) sind und ihre Steueranschlüsse mit einer gemeinsamen Steuerklemmen (VZ) verbunden sind.

11. Digital-Analog-Umsetzer nach Anspruch 5 bis 10, **dadurch gekennzeichnet**, daß die Transistoren der Stromspiegel als Kaskode-Transistorstufen ausgebildet sind.

12. Digital-Analog-Umsetzer nach Anspruch 5 bis 10, **dadurch gekennzeichnet**, daß die Transistoren der Stromspiegel als Wilson-Stromquelle ausgebildet sind.

13. Digital-Analog-Umsetzer nach Anspruch 5 bis 10, **dadurch gekennzeichnet**, daß die Transistoren der Stromspiegel als Improved-Wilson-Stromquelle ausgebildet sind.

14. Digital-Analog-Umsetzer nach Anspruch 5 bis 10, **dadurch gekennzeichnet**, daß mehrere Ausgangstransistoren parallel geschaltet sind.

15. Digital-Analog-Umsetzer nach Anspruch 5 bis 14, **dadurch gekennzeichnet**, daß der Spiegeltransistor (MN2) des ersten Stromspiegels (MN1, MN2, MN3) mit dem Eingangstransistor (MP1) des zweiten Stromspiegels (MP1, MP2) über wenigstens einen, insbesondere zwei gleiche Widerstände verbunden ist.

16. Digital-Analog-Umsetzer nach Anspruch 5 bis 15, **dadurch gekennzeichnet**, daß die Transistoren der Stromspiegel im gleichen Arbeitspunkt betrieben werden.

17. Digital-Analog-Umsetzer nach Anspruch 5 bis 16, **gekennzeichnet** durch eine Beschaltung des Eingangstransistors (MN1) des ersten Stromspiegels gemäß dem kennzeichnenden Teil des Patentanspruchs 5.

18. Digital-Analog-Umsetzer nach Anspruch 5 bis 17, **gekennzeichnet** durch Ausbildung mit komplementären Metalloxid-Halbleitertransistor.

**Claims**

1. Digital-to-analog converter with temperature compensation, having a voltage output with a reference voltage (UREF), having a resistance and switch network (WSN) for converting a digital input code into an analog output current and having an inverting operational amplifier (OPA) fed back by a feedback resistor (RG), characterized in that a reference voltage source is formed with the aid of a reference voltage (UREF) and of a resistor (R) determining the reference current (IREF), which reference current source feeds the resistance and switch network (WSN), and in that the resistor (R) has the same temperature drift as the feedback resistor (RG).

2. Digital-to-analog converter according to Claim 1, characterized in that the feedback resistor (RG) in the feedback branch of the operational amplifier (OPA) has the same value as the resistor (R) determining the reference current (IREF).

3. Digital-to-analog converter according to Claim 1 or 2, characterized in that the reference current source has a current reflector (MN1, MN2; MN1, MN2, MN3, MP1, MP2), the reference input current (IO) of which is determined by the resistor (R) and the reference voltage (UREF).

4. Digital-to-analog converter according to Claim 1 to 3, characterized in that the input transistor (MN1) of the current reflector is connected by its output circuit via the resistor (R) to a reference potential (GND) and by its control input to the output of a further operational amplifier (OPS), at the inverting input (−) of which the reference potential (VREF) is applied and at the non-inverting input (+) of which the potential of the connecting point of the resistor (R) and the output circuit of the input transistor (MN1) are applied.

5. Digital-to-analog converter according to Claim 1 to 4, characterized in that the reference current source is formed by a bipolar reference current source.

6. Digital-to-analog converter according to Claim 5, characterized in that the bipolar reference current source is fed by a bipolar voltage source (VDD, VSS) and contains a first current reflector (MN1, MN2, MN3) with transistors of one type and contains a second current reflector (MP1, MP2) with transistors of another type, which current reflectors have input and output transistors, in that the current reflectors are connected in series to one another and their output transistors can be switched off.

7. Digital-to-analog converter according to Claim 5 or 6, characterized in that the first current reflector (MN1, MN2, MN3) contains a reflecting transistor (MN2) which is connected in series by its output circuit to the output circuit of the input transistor (MP1) of the second current reflector (MP1, MP2).

8. Digital-to-analog converter according to Claim 5 to 7, characterized in that the input transistor (MP1) of the second current reflector (MP1, MP2) is connected as a diode.

9. Digital-to-analog converter according to Claim 5 to 8, characterized in that in each case the output circuit of a transistor (MP3, MN5) is connected upstream of the control terminals of the output transistors (MN3, MP2), and in each case the output circuit of the transistor (MN4, MP4) is connected in parallel to said control terminals and to output terminals on the supply voltage side of the output transistors (MN3, MP2).

10. Digital-to-analog converter according to Claim 5 to 9, characterized in that the transistors (MP3, MN5) connected upstream are of the opposite type and the transistors (MN4, MP4) connected in parallel are of the same type as the respective output transistors (MN3, MP2) and their control terminals are connected to a common control terminal (VZ).

11. Digital-to-analog converter according to Claim 5 to 10, characterized in that the transistors of the current reflectors are constructed as cascode transistor stages.

12. Digital-to-analog converter according to Claim 5 to 10, characterized in that the transistors of the current reflectors are constructed as Wilson current source.

13. Digital-to-analog converter according to Claim 5 to 10, characterized in that the transistors of the current reflectors are constructed as improved Wilson current source.

14. Digital-to-analog converter according to Claim 5 to 10, characterized in that a plurality of output transistors are connected in parallel.

15. Digital-to-analog converter according to Claim 5 to 14, characterized in that the reflecting transistor (MN2) of the first current reflector (MN1, MN2, MN3) is connected to the input transistor (MP1) of the second current reflector (MP1, MP2) via at least one, in particular two identical resistors.

16. Digital-to-analog converter according to Claim 5 to 15, characterized in that the transistors of the current reflectors have the same operating point.

17. Digital-to-analog converter according to Claim 5 to 16, characterized by a wiring of the input transistor (MN1) of the first current reflector according to the characterizing part of Patent Claim 5.

18. Digital-to-analog converter according to Claim 5 to 17, characterized by construction with a complimentary metal oxide semi-conductor transistor.

**Revendications**

1. Convertisseur numérique-analogique à compensation de température à sortie de tension avec une tension de référence (UREF), avec un réseau de résistances et d'interrupteurs (WSN) pour transformer un code numérique d'entrée en un courant de sortie analogique et avec un amplificateur opérationnel inverseur (OPA) monté en contre-couplage à l'aide d'une résistance de rétroaction (RG), caractérisé par le fait que l'on forme, à l'aide de la tension de référence (UREF) et d'une résistance (R) qui détermine le courant de référence (IREF), une source de courant de référence qui alimente le réseau à résistances et à interrupteurs (WSN), et que la résistance (R) possède la même caractéristique de température que celle de la résistance de rétroaction (RG).

2. Convertisseur numérique-analogique selon la revendication 1, caractérisé par le fait que la résistance de rétroaction possède, dans la branche de contre-réaction de l'amplificateur opérationnel la même valeur que la résistance (R) qui détermine le courant de référence (IREF).

3. Convertisseur numérique-analogique selon la revendication 1 ou 2, caractérisé par le fait que la source de courant de référence comporte un miroir de courant (MN1, MN2; MN1, MN2, MN3, MP1, MP2) dont le courant d'entrée de référence (Io) est déterminé par la résistance (R) et par la tension de référence (UREF).

4. Convertisseur numérique-analogique selon les revendications 1 à 3, caractérisé par le fait que le transistor d'entrée (MN1) du miroir de courant est relié par son circuit de sortie et par l'intermédiaire de la résistance (R), à un potentiel de référence (GND), et, par son entrée de commande, à la sortie d'un second amplificateur opérationnel (OPS) à l'entrée inverseuse (–) duquel est appliqué le potentiel de référence (VREF) et à l'entrée non inverseuse (+) duquel est appliqué le potentiel du point de liaison entre la résistance (R) et le circuit de sortie du transistor d'entrée (MN1).

5. Convertisseur numérique-analogique selon les revendications 1 à 4, caractérisé par le fait que la source de courant de référence est formée par une source de courant de référence bipolaire.

6. Convertisseur numérique-analogique selon la revendication 5, caractérisé par le fait que la source de courant de référence bipolaire est alimentée par une source de tension bipolaire (VDD, VSS) et comporte un premier miroir de courant (MN1, MN2, MN3) à transistors d'un premier type et un second miroir de courant à transistors d'un autre type, qui possèdent des transistors d'entrée et de sortie, que les miroirs de courant sont montés en série et que leurs transistors de sortie sont débranchables.

7. Convertisseur numérique-analogique selon la revendication 5 ou 6, caractérisé par le fait que le premier miroir de courant (MN1, MN2, MN3) comporte un transistor-miroir (MN2) dont le circuit de sortie est monté en série avec le circuit de sortie du transistor d'entrée (MP1) du second miroir de courant (MP1, MP2).

8. Convertisseur numérique-analogique selon les revendications 5 à 7, caractérisé par le fait que le transistor d'entrée (MP1) du second miroir de courant (MP1, MP2) est monté en diode.

9. Convertisseur numérique-analogique selon les revendications 5 à 8, caractérisé par le fait qu'en amont des bornes de commande de chacun des transistors de sortie (MN3, MP2) est monté le circuit de sortie d'un transistor (MP3, MN5), alors qu'avec les bornes de sortie, côté alimentation en tension des transistors de sortie (MN3, MP2), sont respectivement montés en parallèle, le circuit de sortie d'un transistor (MN4, MP4).

10. Convertisseur numérique-analogique selon les revendications 5 à 9, caractérisé par le fait que les transistors amont (MP3, MN5) sont de types contraires et les transistors (MN4, MP4) montés en parallèle sont du même type que les transistors de sortie associé (MN3, MP2), et leurs bornes de commande sont reliées à une borne de commande commune (VZ).

11. Convertisseur numérique-analogique selon les revendications 5 à 10, caractérisé par le fait que les transistors des miroirs de courant sont réalisés sous la forme d'étages de transistors en cascade.

12. Convertisseur numérique-analogique selon les revendications 5 à 10, caractérisé par le fait que les transistors de miroirs de courant sont réalisés sous la forme d'une source de courant de Wilson.

13. Convertisseur numérique-analogique selon les revendications 5 à 10, caractérisé par le fait que les transistors des miroirs de courant sont réalisés sous la forme d'une source de courant du type Wilson amélioré.

14. Convertisseur numérique-analogique selon les revendications 5 à 10, caractérisé par le fait que plusieurs transistors de sortie sont montés en parallèle.

15. Convertisseur numérique-analogique selon les revendications 5 à 14, caractérisé par le fait que le transistor-miroir (MN2) du premier miroir de courant (MN1, MN2, MN3) est relié au transistor d'entrée (MP1) du second miroir de courant (MP1, MP2) par l'intermédiaire d'au moins une résistance, en particulier par l'intermédiaire de deux résistances identiques.

16. Convertisseur numérique-analogique selon les revendications 5 à 15, caractérisé par le fait que des transistors des miroirs de courant sont attaqués au niveau du même point de fonctionnement.

17. Convertisseur numérique-analogique selon les revendications 5 à 16, caractérisé par un montage du transistor d'entrée (MN1) du premier miroir de courant selon la partie caractérisante de la revendication 5.

18. Convertisseur numérique-analogique selon les revendications 5 à 17, caractérisé par la réalisation avec des transistors MOS complémentaires.

# FIG 1

# FIG 2